# EUROPEAN PATENT SPECIFICATION

(11) **EP 4 096 350 B1**
(45) Date of publication and mention of the grant of the patent: **03.12.2025**
(21) Application number: 22175328.8
(22) Date of filing: 25.05.2022
(51) Int. Cl.: H05B 6/06

(54) **INDUCTION HEATING DEVICE**
INDUKTIONSERWÄRMUNGSVORRICHTUNG
DISPOSITIF DE CHAUFFAGE PAR INDUCTION

(30) Priority: 25.05.2021 KR 20210067105
(43) Date of publication of application: 30.11.2022
(73) Proprietor: LG Electronics Inc., SEOUL 07336 (KR)
(72) Inventor: JEONG, Sihoon, 08592 Seoul (KR); JANG, Ho Yong, 08592 Seoul (KR); YOON, Bada, 08592 Seoul (KR); KIM, Gwangrok, 08592 Seoul (KR)
(74) Representative: Ter Meer Steinmeister & Partner

(56) References cited:
- CN-A- 103 079 299
- US-A1- 2003 155 349
- US-A1- 2008 049 470
- US-A1- 2020 059 996
- US-A1- 2021 041 384

## Description

### TECHNICAL FIELD

The present disclosure relates to an induction heating device and a method for controlling the induction heating device.

### BACKGROUND

An induction heating device is a device, which includes mechanism that heats a container by generating an eddy current in a metal container, using a magnetic field generated around a working coil. When the induction heating device is driven, an alternating current may be applied to the working coil. Accordingly, an induction magnetic field may be generated around the working coil disposed in the induction heating device. When a magnetic force line of the induced magnetic field generated in this way passes through the bottom of the container having a metal component placed on the working coil, an eddy current may be generated inside the bottom of the container. When the eddy current generated in this way flows through the container, the container itself may be heated.

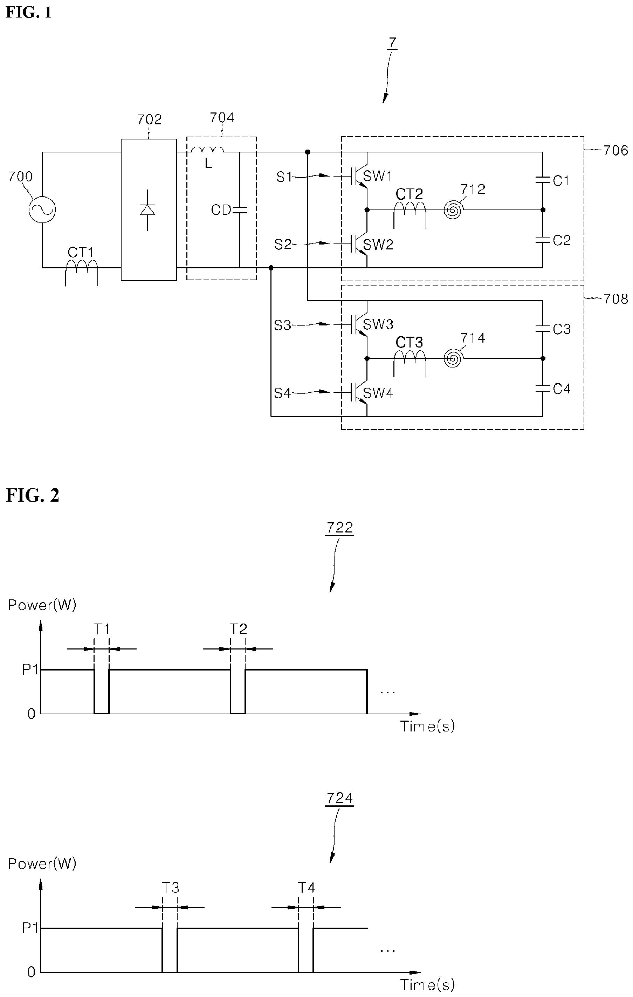

FIG. 1 illustrates a circuit view of an induction heating device according to the prior art.

The induction heating device 7 in FIG. 1 may include two working coils 712 and 714, that is, a first working coil 712 and a second working coil 714. The first working coil 712 and the second working coil 714 may be provided in respective positions corresponding to a first heating area and a second heating area.

The induction heating device 7 according to the prior art may include a rectifier circuit 702, a smoothing circuit 704, a first inverter circuit 706 and a second inverter circuit 708.

The rectifier circuit 702 may include a plurality of diodes and rectify the voltage supplied from an external power source 700. The smoothing circuit 704 may include a first inductor L1 and a first DC link capacitor C1. The smoothing circuit 704 may smooth the voltage output from the rectifier circuit 702 and output a DC voltage.

The first inverter circuit 706 may be a half-bridge inverter circuit including two switching elements SW1 and SW2 and two capacitor elements C1 and C2. The second inverter circuit 708 may be a half-bridge inverter circuit including two switching elements SW3 and SW4 and two capacitor elements C3 and C4.

When the switching elements S1 to S8 are supplied based on the control of a controller, the first inverter circuit 706 and the second inverter circuit 708 may receive current through the rectifier circuit 702 and the smoothing circuit 704, and then convert the input currents into alternating current to supply the converted currents to the first working coil 712 and the second working coil 714, respectively.

Meanwhile, the induction heating device 7 according to the prior art may include a first CT sensor CT1 for sensing the current input to the first working coil 712 and the second working coil 714 (i.e., the input current). Specifically, the induction heating device 7 according to the prior art may include one CT (Current Transformer) sensor configured to sense the input currents to the plurality of the inverter circuits.

In addition, the induction heating device 7 according to the prior art may include a second CT sensor CT2 and a third CT sensor CT3 configured to sense the current flowing through the first working coil 712 and the second working coil 714, that is, the resonance current, when the first working coil 712 and the second working coil 714 are driven.

FIG. 2 is a graph showing the drive timing of the first working coil 712 and the second working coil 714 provided in the induction heating device according to the prior art.

FIG. 2 shows a graph of change in output power values of the first working coil 712 and change in output power values of the second working coil 714, when the first working coil 712 and the second working coil 714 are driven simultaneously.

As shown in FIG. 1, the conventional induction heating device 7 may include one CT sensor, that is, the first CT sensor CT1 for sensing the input currents of the first working coil 712 and the second working coil 714. Accordingly, when the first working coil 712 and the second working coil 714 are driven, the input currents of the first working coil 712 and the second working coil 714 may be alternately sensed to accurately sense the input currents of the inverter circuits.

As one example, as shown in FIG. 2, there are time sections T1, T2, T3 and T4 in which the output power values of the first working coil 712 and the second working coil 714 become 'zero' based on a predetermined period according to the prior art. In the prior art, each working coil is periodically turned on and off, instead of continuously driven.

The controller may sense the input current value of the second working coil 714 for each section T1 and T2 in which the output power value of the first working coil 712 becomes 0 (zero) by using the first CT sensor CT1. Specifically, the controller may obtain an accurate input current value by measuring an input current value of the other inverter circuit, unless one of the working coils is driven.

According to the prior art, the input current values of the plurality of the inverter circuits have to be sensed by using one CT sensor. Thus, there is a disadvantage that a very complicated current measurement method is required to obtain the accurate input values as described with reference to FIG. 2.

In addition, according to the prior art, each of the working coils has to be periodically turned on and off and is not continuously driven, according to the method for measuring the currents described in reference with FIG. 2. Since noise is induced by the periodic turn on and off of the working coils, there could be another disadvantage that the user is likely to feel uncomfortable.

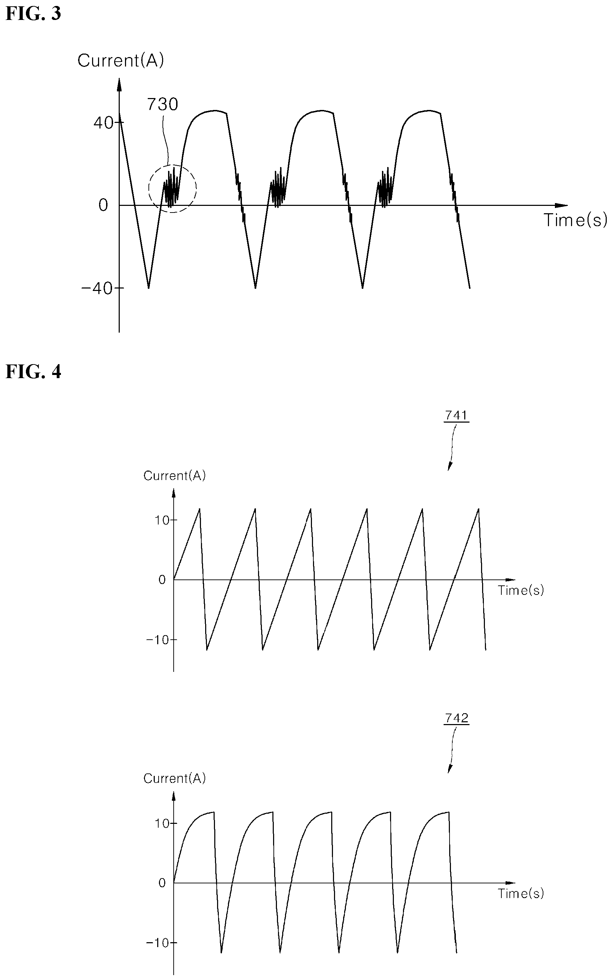

FIG. 3 is a graph showing a waveform of a resonance current obtained by the CT sensor provided in the induction heating device according to the prior art.

According to the prior art, when the first working coil 712 and the second working coil 714 are simultaneously driven, the controller may obtain the resonance current values of the first working coil 712 and the second working coil 714, respectively, using the second CT sensor CT2 and the third CT sensor CT3. FIG. 3 shows the waveform of the resonance current sensed by each of the second CT sensor CT2 and the third CT sensor CT3, when the first working coil 712 and the second working coil 714 are simultaneously driven.

In general, the working coil provided in the conventional heating apparatus is driven in a relatively high frequency band (e.g., 20 kHz to 60 kHz). Accordingly, when the first working coil 712 and the second working coil 714 are simultaneously driven, the driving of one working coil could affect the driving of the other working coil because of the high frequency band. When the resonance current value of one working coil is sensed during the simultaneous driving of the first working coil 712 and the second working coil 714, noise 730 due to the driving of the other working coil may be included in the waveform of the resonance current as shown in FIG. 3.

In addition, the resonance current value of each working coil shown in FIG. 3 may include a positive value and a negative value. However, in the conventional induction heating device according to the prior art, only a positive value may be measured by using the second CT sensor CT2 and the third CT sensor CT3 but a negative value may not be measured disadvantageously.

The prior art may have a problem in that the accurate resonance current value cannot be obtained using the second CT sensor CT2 or the third CT sensor CT3. Accordingly, the controller of the induction heating device according to the prior art may use only some (e.g., peak values) of the resonance current values sensed by the second CT sensor CT2 or the third CT sensor CT3 to control the induction heating device.

FIG. 4 shows a waveform of a resonance current that is sensed when heating a non-magnetic container and a magnetic container, using the induction heating device according to the prior art.

FIG. 4 shows a graph 741 showing a waveform of a resonance current sensed when heating a non-magnetic container through the induction heating device and a graph 742 showing a waveform of a resonance current sensed when heating a magnetic container through the induction heating device.

As shown in FIG. 4, the waveform of the resonance current varies based on the property of the container or vessel heated by using the induction heating device. As mentioned above, the resonance current values sensed by the CT sensors according to the prior art may include noise values. Furthermore, negative current values cannot be sensed. Accordingly, when using the CT sensor according to the prior art, it is impossible to accurately sense the resonance current value of each working coil when heating the containers having different property.

Meanwhile, the CT sensor used to sense the input current resonance current is a sensor configured to generate an alternating current, which is proportional to the current sensed in a primary coil, in a secondary coil based on the principle of a transformer. The CT sensor has a structure including a primary coil and a secondary coil. The CT sensor having the mentioned structure has high unit cost. However, according to the prior art, as the number of the working coils provided in the induction heating device increases, the number of the CT sensors also increases, so that the manufacturing cost of the induction heating device increases.
US2020059996A1 describes an induction-heating cooking apparatus that includes a sensing circuit for controlling an output of a heating coil, which is capable of enhancing accuracy in measuring electric currents of a heating coil by simply modifying a circuit. The induction-heating cooking apparatus includes a control unit calculating an output of a heating coil on the basis of electric currents measured by a sensor supplying alternating current power.
US 2021/041384 A1 describes induction cooktops and operational methods. A method of determining material composition of cookware on an induction cooktop includes determining that a piece of cookware is on the induction cooktop, inducing a current within the piece of cookware with an induction coil of the induction cooktop, and obtaining a peak induction coil current, a smoothed input line current, and a phase shift of current flowing in the induction coil. The method can further include comparing the peak induction coil current, the smoothed input line current, and the phase shift each to a set of predetermined ranges, and determining candidate material compositions for the cookware based on the comparing of each of the peak induction coil current, the smoothed input line current, and the phase shift.

### SUMMARY

One object of the present disclosure is to provide an induction heating device that may easily sense an input current value and a resonance current value of an inverter circuit, without using a complicated sensing method.

Another object of the present disclosure is to provide an induction heating device that may accurately sense an input current value and a resonance value of an inverter circuit, when a plurality of working coils are simultaneously driven.

Another object of the present disclosure is to provide an induction heating device that may accurately sense an input current value and a resonance current value of an inverter circuit regardless of a property of a container to be heated.

Another object of the present disclosure is to provide an induction heating device that may lower the manufacturing cost, compared to the prior art.

Aspects according to the present disclosure are not limited to the above ones, and other aspects and advantages that are not mentioned above can be clearly understood from the following description and can be more clearly understood from the embodiments set forth herein.

The object is solved by the features of the independent claim. Preferred embodiments are given in the dependent claims.

An induction heating device according to the invention is defined by claim 1.

According to thge invention, the current sensing circuit comprises an input current sensing circuit configured to sense an input current value of the inverter circuit based on a current flowing through the shunt resistor; and a resonance current sensing circuit configured to sense a resonance current value of the working coil based on the current flowing through the shunt resistor.

In one or more embodiments, the input current sensing circuit may be connected in parallel to the shunt resistor.

In one or more embodiments, the resonance current sensing circuit may be connected in parallel the shunt resistor.

In one or more embodiments, the input current sensing circuit and the resonance current sensing circuit have the same components.

In one or more embodiments, the input current sensing circuit and the resonance current sensing circuit differ in the frequency of the output current.

Embodiments of the present disclosure may provide an induction heating device including a working coil disposed in a position corresponding to a heating area; an inverter circuit comprising a plurality of switching elements and configured to supply currents to the working coil; a rectifier circuit configured to rectify the voltage supplied from an external power source; a smoothing circuit configured smooth the voltage output from the rectifier circuit; a drive circuit configured to supply a switching signal to each of the switching circuits; a controller configured to supply a control signal for outputting the switching signal to the drive circuit; a shunt resistor connected between the smoothing circuit and the inverter circuit; an input current sensing circuit configured to sense an input current value of the inverter circuit based on a current flowing through the shunt resistor; and a resonance current sensing circuit configured to sense a resonance current value of the working coil based on the current flowing through the shunt resistor. The current sensing circuit may include offset voltage supply circuit; and a comparator configured to output a digital value corresponding to the magnitude of the current flowing through the shunt resistor.

The current sensing circuit may include a noise filter circuit,

The input current sensing circuit may include offset voltage supply circuit; a noise filter circuit; a comparator configured to output a digital value corresponding to the magnitude of the current flowing through the shunt resistor; and a first low-pass filter circuit configured to pass a signal having a preset first frequency or less.

The resonance current sensing circuit may include an offset voltage supply circuit; a noise filter circuit; a comparator configured to output a digital value corresponding to the magnitude of the current flowing through the shunt resistor; and a second low-pass filter circuit configured to pass a signal having a preset second frequency or less.

The first low-pass filter circuit or the second low-pass filter circuit may be a RF filter circuit comprising a resistor element having a predetermined resistance value and a capacitor element having a predetermined capacitance value.

The controller may determine an average value of the current values output from the input current sensing circuit as the input current value of the inverter circuit.

The controller may determine the current value output from the resonance current sensing circuit as the resonance current value of the working coil.

The input current sensing circuit and the resonance current sensing circuit sense may be configured to sense current signals having different frequencies.

The current values output from the input current sensing circuit and the resonance sensing circuit may be positive values.

According to embodiments, the induction heating device is capable of easily sensing an input current value and a resonance current value of an inverter circuit, without using a complicated sensing method.

According to embodiments, the induction heating device is capable of accurately sensing an input current value and a resonance value of an inverter circuit, when a plurality of working coils are simultaneously driven.

According to embodiments, the induction heating device is capable of accurately sensing an input current value and a resonance current value of an inverter circuit regardless of property of a container to be heated.

According to embodiments, the manufacturing cost of the induction heating device can be lowered, compared to the prior art.

### BRIEF DESCRIPTION OF DRAWINGS

FIG. 1 is a circuit view of an induction heating device according to the prior art;
FIG. 2 is a graph showing the driving timing of a first working coil and the drive timing of a second working coil provided in the induction heating device according to the prior art;
FIG. 3 is a graph showing a waveform of a resonance current obtained by a CT sensor provided in the induction heating device according to the prior art;
FIG. 4 shows a waveform of a resonance current that is sensed when heating a non-magnetic container and a magnetic container, using the induction heating device according to the prior art;
FIG. 5 is an exploded perspective view of an induction heating device according to an embodiment of the present disclosure;
FIG.6 block diagram of an induction heating device of a embodiment of the present disclosure;
FIG. 7 is a circuit view of an input current sensing circuit or a resonance current sensing circuit provided in an induction heating device according to an embodiment of the present disclosure;
FIG. 8 is a graph showing an output power value of a working coil based on a power level input when heating a magnetic container and a non-magnetic container using the induction heating device according to the prior art; and
FIG. 9 is a graph showing an output power value of a working coil based on a power level input when heating a magnetic container and a non-magnetic container using an induction heating device according to an embodiment of the present disclosure.

### DETAILED DESCRIPTION

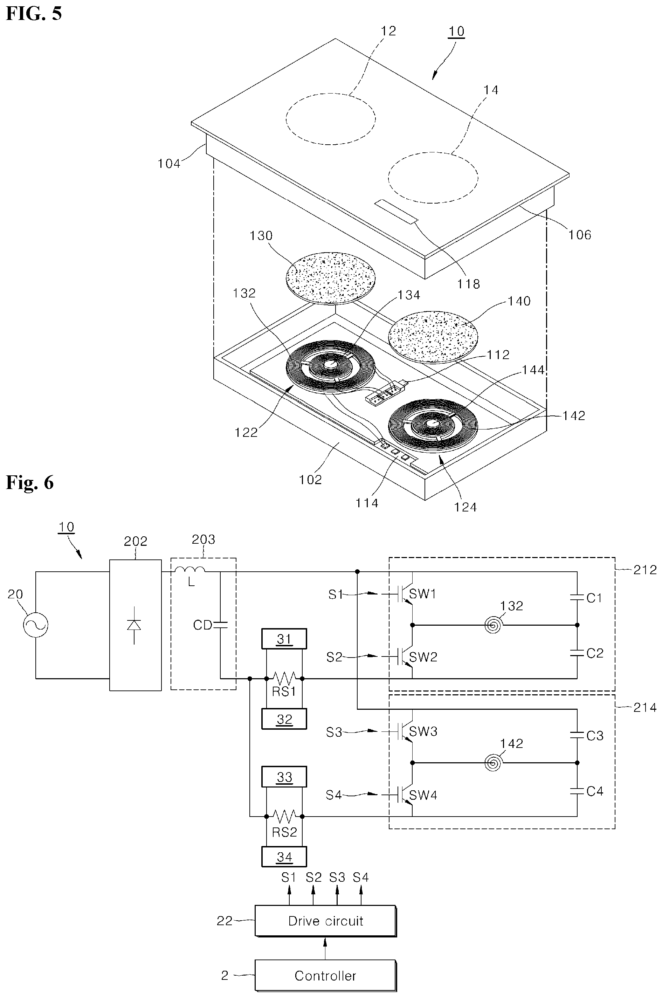

FIG. 5 is an exploded perspective view of an induction heating device according to an embodiment of the present disclosure.

Referring to FIG. 5, the induction heating device 10 may include a case 102 defining a main body, and a cover plate 104 coupled to the case 102 and sealing or covering the case 102.

The cover plate 104 may be coupled to an upper surface of the case 102 to close the space formed in the case 102 from the outside. The cover plate 104 may include a top plate 106 on which an object to be heated (i.e., a container for cooking food) is placed. The top plate 106 may be made of a tempered glass material such as ceramic glass, but is not limited thereto. The material of the top plate 106 may vary according to embodiments.

A first heating area 12 and a second heating area 14 corresponding to working coil assemblies 122 and 124, respectively, may be formed in or on the top plate 106. Lines or figures corresponding to the heating areas 12 and 14 may be printed or displayed on the top plate 106 in order for a user to clearly recognize the positions of the heating areas 12 and 14.

The case 102 may have a hexahedral shape with an open top. However, the shape of the case 102 is not limited an can have other shapes.

The working coil assembly 122 and 124 for heating a container or vessel may be disposed in the space formed inside the case 102. The number of working coil assemblies 122 and 124 is not limited. Exemplary, there are two working coil assemblies 122 and 124. However, there might be only one or three or more working coil assemblies inside the case 102.

In addition, an interface unit 114 may be provided inside the case 102. The interface unit 114 may have functions to adjust or set a power level of each of the heating areas 12 and 14 and/or to display related information of the induction heating device 10. The interface unit 114 may be a touch panel that is capable of both inputting information and displaying information by touch, but the interface unit 114 may have a different structure, e.g. a separate input button and a display being located at a another place..

A manipulation region 118 may be formed in a position corresponding to the interface unit 114 in the top plate 106. For user manipulation, characters or images may be printed on the manipulation region 118. The user may perform a desired operation by touching a specific point of the manipulation region 118 with reference to the characters or images pre-printed on the manipulation region 118. In addition, the information output by the interface unit 114 may displayed through the manipulation region 118.

The user may set and adjust the power level of each heating area 12 and 14 through the interface unit 114. The power level may be indicated by a number (e.g., 1, 2, 3, ... and 9) on the manipulation region 118. When the power level for each heating area 12 and 14 is set, the required power value and the heating frequency of the working coil assemblies 122, 124 responding to the respective heating areas 12 and 14 may be determined. A controller 2 (not shown in Fig. 5) may be provided to drive each of the working coils 132, 142 or the working coil assemblies 122, 124 so that the actual output power value can match the required power value set by the user based on the determined heating frequency.

Inside the case 102 there may be further provided a power source part 112 for supplying power to the first working coil assembly 122, the second working assembly 124 and the interface unit 114 and/or other electrical components.

In the embodiment of FIG. 2, two working coil assemblies (i.e., the first working coil assembly 122 and the second working coil assembly 124) are disposed inside the case 102. However, three or more working coil assemblies may be provided in the case 102 according to some embodiments.

Each working coil asembly 122 and 124 may include a working coil 132, 142 configured to induce an magnetic field using a high frequency alternating current supplied by the power source part 112. An insulating sheet may be provided to protect the coil 132, 142 from heat generated by the container. For example, the first working assembly 122 shown in FIG. 2 may include a first working coil 132 for heating the container put in the first heating area 12 and a first insulating sheet 130. The second working assembly 124 may include a second working coil 142 and a second insulating sheet 140. The insulating sheet may be omitted ot may not be provided according to embodiments.

In addition, a temperature sensor may be provided at the center of each working coil 132 and 142. For example, a temperature sensor 134 may be provided in the center of the first working coil 132 and a second temperature sensor 144 may be provided in the center of the second working coil 142 as shown in FIG. 2. The temperature sensor may measure the temperature of the container put in each heating area.

In one embodiment of the present disclosure, the temperature sensor may be a thermistor temperature sensor having a variable resistance of which a resistance value changes according to the temperature of the container, but is not limited thereto.

In the embodiment, the temperature sensor may output a sensing voltage corresponding to the temperature of the container. The sensing voltage output from the temperature sensor may be transmitted to a controller 2.

The controller 2 may check the temperature of the container based on the magnitude of the sensing voltage output from the temperature sensor 134, 144. When the temperature of the container corresponds to a preset reference value or more, the controller 2 may perform an overheat protection operation of lowering the actual power value of the working coil 132, 142 or stopping the driving of the working coil 132. 142.

Although not shown in FIG. 5, a circuit board may be disposed in the space formed inside the case 102, wherein a plurality of circuits or elements including the controller2 may be placed on such circuit board.

The controller 2 may perform a heating operation by driving each of the working coils 132 and 142 based on the user's heating start command input through the interface unit 114. When the user inputs a heating terminating command through the interface unit 114, the controller 2 may stop the driving of each of the working coils 132 and 142 to terminate the heating operation.

FIG. 6 is a block diagram of an induction heating device according to one embodiment of the present disclosure.

Referring to FIG. 6, the induction heating device 10 according to the embodiment may include a rectifier circuit (or a rectifier) 202, a smoothing circuit 203, a first inverter circuit (or a first inverter) 212, a first working coil 132, a second inverter circuit (or a second inverter) 214, a second working coil 142, a controller 2 and a drive circuit (or a driver) 22.

The rectifier circuit 202 may include a plurality of diode elements. In one embodiment of the present disclosure, the rectifier circuit 202 may be a bridge diode circuit. However, it may be another type circuit depending on embodiments. The rectifier 202 may rectify the AC input voltage supplied from the external power source 20 to output a voltage having a pulsating waveform.

The smoothing circuit 203 may smooth the voltage rectified by the rectifer circuit 202 to output a DC link voltage. The smoothing circuit 203 may be include an inductor L and a DC link capacitor CD.

The first inverter circuit may include a first switching element SW1, a second switching 212 , element SW2, a first capacitor C1 and a second capacitor C2. The first switching element SW1 and the second switching element SW2 may be connected in series with each other. The first capacitor C1 and the second capacitor C2 may be connected in series with each other. The first working coil 132 may be connected between the connection point of the first switching element SW1 and the second switching element SW2 and the connection point of the first capacitor C1 and the second capacitor C2. The first inverter circuit 212 may convert the current output from the smoothing circuit 204 into an AC current, and supply the converted AC current to the first working coil 132.

The second inverter circuit 214 may include a third switching element SW3, a fourth switching element SW4, a third capacitor C3 and a fourth capacitor C4. The third switching element SW3 and the fourth switching element SW4 may be connected in series with each other. The third capacitor C3 and the fourth capacitor C4 may be connected in series with each other. The second working coil 142 may be connected between the connection point of the third switching element SW3 and the fourth switching element SW4 and the connection point of the third capacitor C3 and the fourth capacitor C4. The second inverter circuit 214 may convert the current output from the smoothing circuit 204 into an AC current, and supply the converted AC current to the second working coil 142.

The DC link voltage input to the inverter circuits 212 and 214 may be converted into the alternating current by the turn-on and turn-off (i.e., the switching operation) of the switching elements SW1, SW2, SW3 and SW4 of the inverter circuits 212 and 214. The alternating currents converted by the inverter circuits 212 and 214 may be supplied to the working coils 132 and 142, respectively. When the alternating current is supplied to the working coils 132 and 142, there may be a resonance phenomenon in the working coils and an eddy current may flow to heat the container.

In one embodiment of the present disclosure, the first switching element SW1 and the second switching element SW2 may be alternately turned on and off. The third switching element SW3 and the fourth switching element SW4 may be alternately turned on and off.

The controller 2 may output a control signal for controlling the drive circuit 22. The drive circuit 22 may supply switching signals S1, S2, S3 and S4 to the switching elements SW1, SW2, SW3 and SW4 based on the control signal supplied by the controller 2, respectively. In the present disclosure, the first switching signal S1, the second switching signal S2, the third switching signal S3 and the fourth switching S4 may be pulse width modulation (PWM) signals each having a predetermined duty cycle.

When the AC current output from the inverter circuit 212 and 214 is supplied to the working coil 132 and 142, the working coil 132 and 142 may be driven. While eddy current flows through the container put on the working coil 132 and 142, with the driving of the working coil 132 and 142, the container may be heated. The amount of thermal energy supplied to the container may vary based on the amount of power actually generated by the driving of the working coil, that is, the actual output power value of the working coil.

When the user changes a current state of the induction heating device 10 into a power-on state by manipulating the input interface 114 via the manipulation region 118, an external power source device 20 may supply power to the induction heating device 10 and the induction heating device 10 may enter or start a driving standby state. Hence, the user may place a svessel or container on the first heating are 12 and/or the second heating area 14 and set a power value required for the heating area 12 and the second heating area 14 to start a heating start command. Once the user inputs the heating start command, the controller 2 may determine a required power value of each working coil 132 and 142 corresponding to the power level set by the user.

The controller 2 having received the heating start command may determine a frequency corresponding to the required power value of each working coil 132 and 142, namely, a heating frequency, and supply a control signal corresponding to the determined heating frequency to the drive circuit 22. Accordingly, the switching signals S1, S2, S2 and S4 may be output from the drive circuit 22 and the working coils 132 and 142 may be driven as the switching signals S1, S2, S3 and S4 are input to the switching elements SW1, SW2, SW3 and SW4, respectively. Hence, the working coils 132 and 142 may be driven so that the eddy current can flow through the container to be heated.

In this implementation, the controller 2 may determine the heating frequency that is the frequency corresponding to the power level set by the user. As one example, the user sets a power level for the heating area. Then, the controller 2 may gradually lower the driving frequency of the inverter circuit 212 and 214, until the output power value of the working coil 132 and 142 becomes equal to the required power value corresponding to the power level set by the user in a state where the driving frequency of the inverter circuit 212 and 214 is set to a preset reference frequency. The controller 2 may determine the frequency when the output power value of the working coil 132 and 142 becomes equal to the required power value to be the heating frequency.

The controller 2 may supply a control signal corresponding to the determined heating frequency to the drive circuit 22. The drive circuit 22 may output switching signals S1, S2, S3 and S4 having a predetermined duty ratio corresponding to the heating frequency determined by the controller based on the control signal output by the controller 2. While the switching elements SW1, SW2, SW3 and SW3 are alternately turned on and off by the input of the switching signals S1, S2, S3 and S4, the AC current may be supplied to the working coil 132 and 142. Accordingly, the container placed on the heating area 14 may be heated.

Meanwhile, the induction heating device 10 according to one embodiment may include shunt resistors RS1 and RS2. In the example of FIG. 6, the first shunt resistance RS1 may be connected between the smoothing circuit 203 and the first inverter circuit 212. The second shunt resistor RS2 may be connected between the smoothing circuit 203 and the second inverter circuit 214.

The induction heating device 10 according to one embodiment may include input current sensing circuits 31 and 33 configured to sense the currents input to the inverter circuits 212 and 214 based on the currents flowing to the shunt resistors RS1 and RS2, namely, the input currents of the inverter circuits 212 and 214, respectively.

In the example of FIG. 6, the first input current sensing circuit 31 may sense the current input to the first inverter circuit 212, namely, the input current of the first inverter circuit 212. The second input current sensing circuit 33 may sense the current input to the second inverter circuit 214, namely, the input current of the second inverter circuit 214.

The induction heating device 10 according to one embodiment may further include resonance current sensing circuits 32 and 34 configured to sense the current flowing through the working coils 132 and 142 based on the current flowing in the shunt resistors RS1 and RS2, namely, the resonance current of the working coils 132 and 142.

In the example of FIG. 6, the first resonance current sensing circuit 32 may sense the current flowing in the first working coil 132, namely, the resonance current of the first working coil 132. The second resonance current sensing circuit 34 may sens the current flowing in the second working coil 142, namely, the resonance current of the second working coil 142.

The controller 2 may determine the input current value of the inverter circuit 212 and 214 based on the current value output from the input current sensing circuit 31 and 33. In addition, the controller 2 may determine the resonance current value of the working coil 132 and 142 based on the current value output from the resonance current sensing circuit 32 and 34.

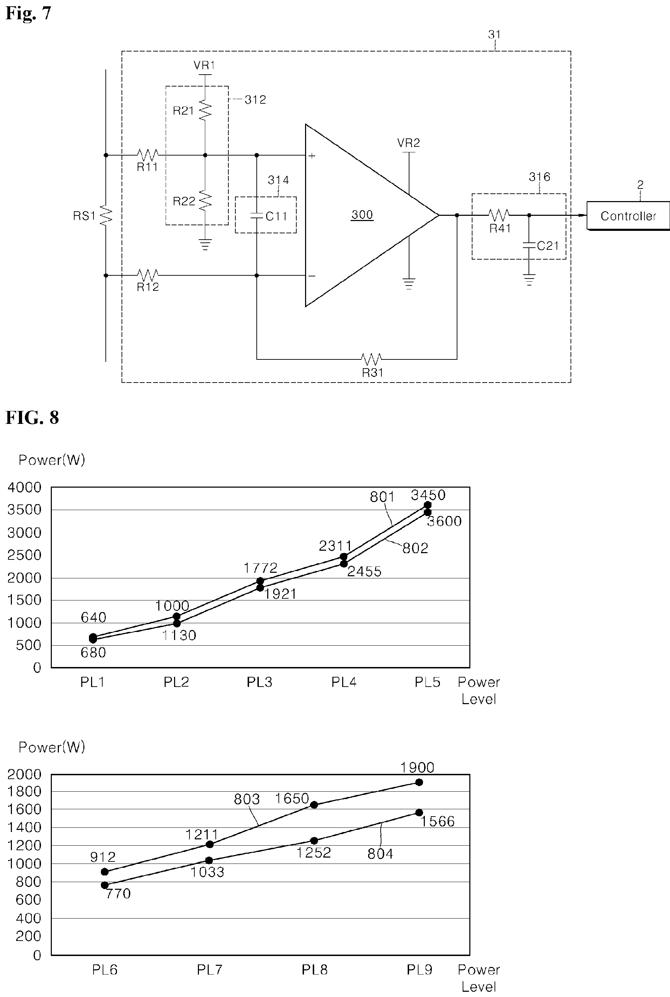

FIG. 7 is a circuit view of an input current sensing circuit 31, 33 or a resonance current sensing circuit 32, 34 provided in an induction heating device 10 according to the embodiment of the present disclosure.

In FIG. 7, only the circuit view of the first input current sensing circuit 31 is shown. However, the second input current sensing circuit 33, the first resonance current sensing circuit 32, and the second resonance current sensing circuit 34 shown in FIG. 2 may have the same circuits as the first input current sensing circuit 31 shown in FIG. 7.

Referring to FIG. 7, the first current sensing circuit 31 may include an off-set voltage supply circuit 312, a noise filter circuit 314, a comparator 300 and a low pass filter 316.

The offset voltage supply circuit 312 may include a first voltage divider resistor R21 and a second voltage divider R22 that are connected in series with each other. The offset voltage supply circuit 312 may supply an offset voltage to the comparator 300 based on a first reference voltage VR1. The magnitude of the current flowing through the first shunt resistor RS1, namely, the current value may be a positive value or a negative value. When the offset voltage is supplied by the offset voltage supply circuit 312, the current value output from the comparator 300 may always become a positive value.

To set or adapt an input current, resistors R11 and R12 may be provided in front of the offset voltage supply circuit 312.

The magnitude of the offset voltage supplied by the offset voltage supply circuit 312 may vary based on resistance values of the first voltage divider resistor R21 and the second voltage divider resistor R22. The magnitude of the offset voltage supplied by the offset voltage supply circuit 312 may be set so that the current value output from the comparator 300 may be always a positive value

The noise filter circuit 314 may include a capacitor C11. The noise filter circuit 314 may serve to remove the noise generated in the process of sensing a current value flowing through the first shunt resistor RS1. For example, when the first working coil 132 and the second working coil 142 are being driven simultaneously, the noise signal generated by the second working coil 142 may be filtered by the noise filter circuit 314, so that the magnitude of the first shunt resistor Rs1 may be more accurately sensed.

The comparator 300 may output a digital value corresponding to the magnitude of the current flowing through the first shunt resistor RS1. As mentioned above, the comparator 300 may be set to always output a positive value by the offset voltage supplied by an offset voltage supply circuit 312.

The low-pass filter circuit 316 may be an RC filter circuit including a resistor R41 and a capacitor C21. The low-pass filter circuit 316 may filter a signal having a predetermined reference frequency or more.

The filtering range of the low-pass filter circuit 316 may vary based on a resistance value of the resistor R41 and a capacitance value of the capacitor C21.

In the example of the present disclosure, a first low-pass filter circuit 316 provided in the input current sensing circuit 31 and 33 may pass a signal having a predetermined reference frequency or less (e.g., 20Hz or 120Hz). Accordingly, the input current sensing circuit 31 and 33 may sense only a current component corresponding to the input current among the current components flowing through the shunt resistors RS1 and RS2 to output an input current value.

The controller 2 may determine the magnitude of the input current input to the inverter circuit 212 and 214 based on the current values output from the input current sensing circuit 31 and 33.

In one example of the present disclosure, the controller 2 may calculate an average value of current values output from the input current sensing circuit 31 and 33, and determine the calculated average value as the input current value of the inverter circuit 212 and 214.

In addition, a second low-pass filter circuit provided in the resonance current sensing circuit 32 and 34 may pass a signal having a predetermined reference frequency or less (e.g., 100kHz). Accordingly, the resonance current sensing circuit 32 and 34 may sense only a current component corresponding to the resonance current among the current components flowing through the shunt resistors RS1 and RS2 to output a resonance current value.

The controller 2 may determine the magnitude of the resonance current flowing through the working coil 132 and 142 based on the current value output from the resonance current sensing circuit 32 and 34. In one example of the present disclosure, the controller 2 may determine the current value output from the resonance current sensing circuit 32 and 34 to be the resonance current value of the working coil 132 and 142.

In implementations, a first reference frequency and a second reference frequency may vary according to embodiments of the present disclosure. Also, the resistance value of the resistor R41 and the capacitance value of the capacitor C21 for determining the first reference frequency and the second reference frequency may be set to be variable according to each embodiment.

As mentioned above, the induction heating device 10 may sense the input current value and the resonance current value based on the magnitude of the current flowing through the shunt resistors RS1 and RS2 connected between the smoothing circuit 203 and the inverter circuits 212 and 214.

Unlike the prior art, the induction heating device according to one embodiment of the present disclosure may separately include input current sensing circuits corresponding to respective inverter circuits. Accordingly, the induction heating device may efficiently and easily sense the input current value, without complicated controlling methods for sensing the input current value.

So, according to the invention a shunt resistor RS1 and RS 2 is placed between the smoothing circuit 203 and the inverter circuits 212, 214, respectively.

Thus, the input current sensing circuits 31 and 33 and the resonance current sensing circuits 32 and 34 can placed between the smoothing circuit 203 and the inverter circuits 212, 214, respectively and measure the input current supplied to the inverter circuits 212, 214.

In particular, the input current sensing circuits 31 and 33 and the resonance current sensing circuits 32 and 34 are placed in parallel to the shunt resistors RS1 and RS2, respectively. That means the input current sensing circuit 31 and the resonance current sensing circuit 32 are connected in parallel to the shunt resistor RS1 of the first inverter circuit 212.

Furthermore, the input current sensing circuit 33 and the resonance current sensing circuit 34 are connected in parallel to the shunt resistor RS2 of the second inverter circuit 214.

Each of the input current sensing circuits 31 and 33 and the resonance current sensing circuits 32 and 34 may include a noise filter circuit 314. Accordingly, when the plural working coils are driving at the same time, the noise signal generated by the driving of the other working coil may be removed and the input current value or the resonance current value may be sensed more accurately.

In this embodiment, due to the supply of the offset voltage, the input current value or the resonance current value may be always output as a positive value. Accordingly, it may be possible to completely restore the input current or the resonance current, and also it may be possible to obtain the more accurate input current value or resonance current value, so that more precise control of the induction heating device can become possible by using the input current value or the resonance current value.

In addition, even if the property of the container heated by the working coil area changed, it may be always possible to accurately sense the input current value or the resonance current value based on the digital value output from the input current sensing circuit or the resonance current sensing circuit.

The input current sensing circuit or the resonance current sensing circuit according to the embodiment of the present disclosure may be configured of a low-cost circuit including a resistor, a capacitor and a comparator, so that there may be an advantage in that the manufacturing cost of the induction heating device may be lower than that of the conventionally used CT sensor.

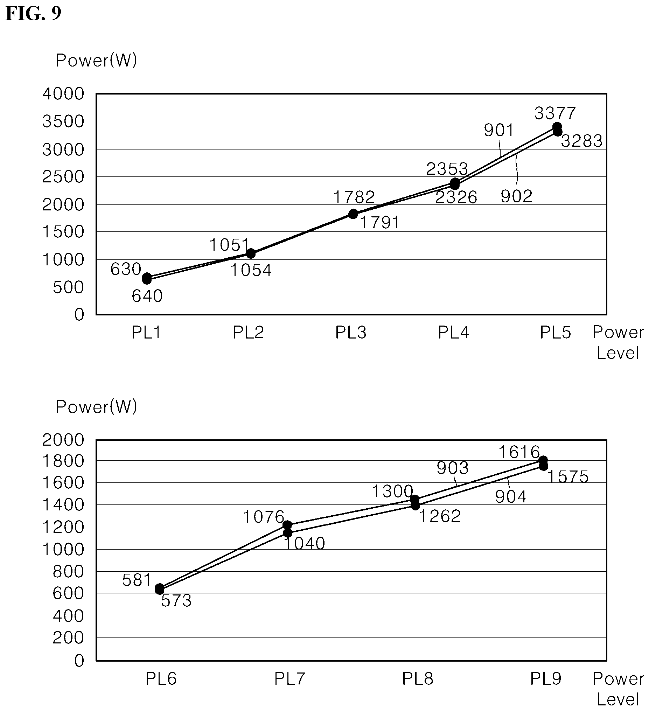

FIG. 8 is a graph showing an output power value of the working coil based on a power level input when the conventional heating apparatus according to the prior art heats a magnetic and non-magnetic container. FIG. 9 a graph showing an output power value of the working coil based on a power level input when the heating apparatus according to the embodiment of the present disclosure heats a magnetic and non-magnetic container.

FIG. 8 includes a graph 801 showing the output power value of the working coil calculated by the controller based on the input current value sensed when the conventional induction heating device heats the magnetic container and a graph 802 showing the output power value of the working coil actually measured by an auxiliary measuring device.

In addition, FIG. 8 includes a graph 803 showing the output power value of the working coil calculated by the controller based on the input current value sensed when the conventional induction heating device heats the non-magnetic container and a graph 804 showing the output power value of the working coil actually measured by the auxiliary measuring device.

As shown in FIG. 8, there is a difference between the output power value of the working coil calculated by the controller based on the input current value sensed when the container is heated and that of the working coil measured by the auxiliary measuring device. Especially, as shown in the graph 803 and the graph 804, when the non-magnetic container is heated through the working coil, the difference between the output power value of the working coil calculated by the controller based on the input current value and the output power value of the working coil actually measured through the auxiliary measuring device may become larger.

This means that the input current value sensed based according to the prior art, e.g by a current transformer as shown in Fig. 1, is inaccurate compared to the actual input current value. Furthermore as shown in FIG. 8, the accuracy of sensing the input current value also depends on the property of the container change and is further lowered.

Meanwhile, FIG. 9 includes a graph 901 showing the output power value of the working coil calculated by the controller based on the input current value sensed when the induction heating device according to one embodiment of the present disclosure heats the magnetic container. Also, FIG. 9 includes a graph 902 showing the output power value of the working coil actually measured by the auxiliary measuring device.

In addition, FIG. 9 includes a graph 903 showing the output power value of the working coil calculated by the controller based on the input current value sensed when the induction heating device according to one embodiment of the present disclosure heats the non-magnetic container. Also, FIG. 9 includes a graph 904 showing the output power value of the working coil actually measured by the auxiliary measuring device.

Referring to FIG. 9, the difference between the output power value of the working coil calculated by the controller based on the input current value and the output power value of the working coil actually measured through the auxiliary measuring device may get reduced, compared to the prior art. This means that the sensing accuracy of the input current value measured by the controller is increased, compared to the prior art.

As shown in FIG. 9, the induction heating device according to the embodiment of the present disclosure may always accurately sense the input current value regardless of the property of the container.

## Claims

1. An induction heating device (10) comprising:
a working coil (132, 142) disposed in a position corresponding to a heating area (12, 14);
an inverter circuit (212, 214) comprising a plurality of switching elements (SW1, SW2, SW3, SW4) and configured to supply a current to the working coil (132, 142);
a rectifier circuit (202) configured to rectify the voltage supplied from an external power source (20);
a smoothing circuit (203) configured to smooth the voltage output from the rectifier circuit (202);
a drive circuit (22) configured to supply a switching signal (S1, S2, S3, S4) to each of the switching circuits (SW1, SW2, SW3, SW4);
a controller (2) configured to supply a control signal to the drive circuit (22) for outputting the switching signal (S1, S2, S3, S4) by the drive circuit (22);
a shunt resistor (RS1, RS2) connected between the smoothing circuit (203) and the inverter circuit (212, 214),
**characterised by**
a current sensing circuit (31, 32, 33, 34) configured to sense an input current value of the inverter circuit (212) based on a current flowing through the shunt resistor (RS1, RS2) and to sense a resonance current value of the working coil (132, 142) based on the current flowing through the shunt resistor (RS1, RS2), wherein the current sensing circuit (31, 32, 33, 34) comprises:
an input current sensing circuit (31, 33) configured to sense an input current value of the inverter circuit (212) based on a current flowing through the shunt resistor (RS1, RS2); and
a resonance current sensing circuit (32, 34) configured to sense a resonance current value of the working coil (132, 142) based on the current flowing through the shunt resistor (RS1, RS2)

2. The induction heating device of claim 1, wherein the input current sensing circuit (31, 33) is connected in parallel to the shunt resistor (RS1, RS2); and/or the resonance current sensing circuit (32, 34) is connected in parallel the shunt resistor (RS1, RS2).

3. The induction heating device of claim 1 or 2, wherein the input current sensing circuit (31, 33) and the resonance current sensing circuit (32, 34) have the same components.

4. The induction heating device of any one of the preceding claims, wherein the current sensing circuit (31, 33) comprises:
an offset voltage supply circuit (312);
a comparator (300) configured to output a digital value corresponding to the magnitude of the current flowing through the shunt resistor (RS1, RS2).

5. The induction heating device of any one of the preceding claims, wherein the current sensing circuit (31, 32, 33, 34) comprises a noise filter (314).

6. The induction heating device of claim 5, wherein the noise filter circuit (314) include a capacitor (C11) and is configured to remove the noise when the first working coil (132) and the second working coil (142) are being driven simultaneously.

7. The induction heating device of any one of the preceding claims 2-6, wherein the input current sensing circuit (31, 33) comprises a first low-pass filter circuit (316) configured to pass a signal having a preset first frequency or less.

8. The induction heating device of any one of the preceding claims, wherein the resonance current sensing circuit comprises (32, 34) a second low-pass filter circuit (316) configured to pass a signal having a preset second frequency or less.

9. The induction heating device of claim 7 or 8, wherein the first low-pass filter circuit (316) and/or the second low-pass filter circuit (316) is a RF filter circuit comprising a resistor element (R41) having a predetermined resistance value and a capacitor element (C21) having a predetermined capacitance value.

10. The induction heating device of any one of the preceding claims 4-9, wherein the offset voltage supply circuit (312) includes a first voltage divider resistor (R21) and a second voltage divider resistor (R22), wherein the offset voltage supply circuit (312) is configured to supply an offset voltage to the comparator (300) based on a first reference voltage (VR1).

11. The induction heating device of any one of the preceding claims **1-10,** wherein the controller (2) is configured to determine an average value of the current values output from the input current sensing circuit (31, 33) as the input current value of the inverter circuit (212, 214).

12. The induction heating device of any one of the preceding claims 1-11, wherein the controller (2) is configured to determine the current value output from the resonance current sensing circuit (32, 34) as the resonance current value of the working coil (132, 142).

13. The induction heating device of any one of the preceding claims 2-12, wherein the input current sensing circuit (31, 33) and the resonance current sensing circuit (32, 34) are configured to sense current signals having different frequencies.

14. The induction heating device of any one of the preceding claims, wherein the current values output from the input current sensing circuit (31, 33) and the resonance sensing circuit (32, 34) are positive values.

## Patentansprüche

1. Induktionsheizvorrichtung (10), die umfasst:
eine Arbeitsspule (132, 142), die an einer einem Heizbereich (12, 14) entsprechenden Stelle angeordnet ist;
eine Wechselrichterschaltung (212, 214), die mehrere Schaltelemente (SW1, SW2, SW3, SW4) umfasst und konfiguriert ist, der Arbeitsspule (132, 142) einen Strom zuzuführen;
eine Gleichrichterschaltung (202), die konfiguriert ist, die von einer externen Leistungsquelle (20) zugeführte Spannung gleichzurichten;
eine Glättungsschaltung (203), die konfiguriert ist, die von der Gleichrichterschaltung (202) ausgegebene Spannung zu glätten;
eine Ansteuerschaltung (22), die konfiguriert ist, jeder der Schaltschaltungen (SW1, SW2, SW3, SW4) ein Schaltsignal (S1, S2, S3, S4) zuzuführen;
eine Steuereinheit (2), die konfiguriert ist, der Ansteuerschaltung (22) ein Steuersignal zum Ausgeben des Schaltsignals (S1, S2, S3, S4) durch die Ansteuerschaltung (22) zuzuführen;
einen Nebenschlusswiderstand (RS1, RS2), der zwischen der Glättungsschaltung (203) und der Wechselrichterschaltung (212, 214) verbunden ist,
**gekennzeichnet durch**
eine Stromerfassungsschaltung (31, 32, 33, 34), die konfiguriert ist, auf der Grundlage eines über den Nebenschlusswiderstand (RS1, RS2) fließenden Stroms einen Eingangsstromwert der Wechselrichterschaltung (212) zu erfassen und auf der Grundlage des über den Nebenschlusswiderstand (RS1, RS2) fließenden Stroms einen Resonanzstromwert der Arbeitsspule (132, 142) zu erfassen, wobei die Stromerfassungsschaltung (31, 32, 33, 34) umfasst:
eine Eingangsstrom-Erfassungsschaltung (31, 33), die konfiguriert ist, auf der Grundlage eines über den Nebenschlusswiderstand (RS1, RS2) fließenden Stroms einen Eingangsstromwert der Wechselrichterschaltung (212) zu erfassen; und
eine Resonanzstrom-Erfassungsschaltung (32, 34), die konfiguriert ist, auf der Grundlage des über den Nebenschlusswiderstand (RS1, RS2) fließenden Stroms einen Resonanzstromwert der Arbeitsspule (132, 142) zu erfassen.

2. Induktionsheizvorrichtung nach Anspruch 1, wobei die Eingangsstrom-Erfassungsschaltung (31, 33) zu dem Nebenschlusswiderstand (RS1, RS2) parallelgeschaltet ist; und/oder die Resonanzstrom-Erfassungsschaltung (32, 34) zu dem Nebenschlusswiderstand (RS1, RS2) parallelgeschaltet ist.

3. Induktionsheizvorrichtung nach Anspruch 1 oder 2, wobei die Eingangsstrom-Erfassungsschaltung (31, 33) und die Resonanzstrom-Erfassungsschaltung (32, 34) dieselben Komponenten aufweisen.

4. Induktionsheizvorrichtung nach einem der vorhergehenden Ansprüche, wobei die Stromerfassungsschaltung (31, 33) umfasst:
eine Offset-Spannungs-Zuführungsschaltung (312);
einen Komparator (300), der konfiguriert ist, einen digitalen Wert auszugeben, der der Größe des über den Nebenschlusswiderstand (RS1, RS2) fließenden Stroms entspricht.

5. Induktionsheizvorrichtung nach einem der vorhergehenden Ansprüche, wobei die Stromerfassungsschaltung (31, 32, 33, 34) ein Rauschfilter (314) umfasst.

6. Induktionsheizvorrichtung nach Anspruch 5, wobei die Rauschfilterschaltung (314) einen Kondensator (C11) enthält und konfiguriert ist, das Rauschen, wenn die erste Arbeitsspule (132) und die zweite Arbeitsspule (142) gleichzeitig angesteuert werden, zu entfernen.

7. Induktionsheizvorrichtung nach einem der vorhergehenden Ansprüche 2-6, wobei die Induktionsstrom-Erfassungsschaltung (31, 33) eine erste Tiefpassfilterschaltung (316), die konfiguriert ist, ein Signal mit einer im Voraus festgelegten ersten Frequenz oder kleiner durchzulassen, umfasst.

8. Induktionsheizvorrichtung nach einem der vorhergehenden Ansprüche, wobei die Resonanzstrom-Erfassungsschaltung (32, 34) eine zweite Tiefpassfilterschaltung (316), die konfiguriert ist, ein Signal mit einer im Voraus festgelegten zweiten Frequenz oder kleiner durchzulassen, umfasst.

9. Induktionsheizvorrichtung nach Anspruch 7 oder 8, wobei die erste Tiefpassfilterschaltung (316) und/oder die zweite Tiefpassfilterschaltung (316) eine HF-Filterschaltung ist, die ein Widerstandselement (R41) mit einem vorgegebenen Widerstandswert und ein Kondensatorelement (C21) mit einem vorgegebenen Kapazitätswert umfasst.

10. Induktionsheizvorrichtung nach einem der vorhergehenden Ansprüche 4-9, wobei die Offset-Spannungs-Zuführungsschaltung (312) einen ersten Spannungsteilerwiderstand (R21) und einen zweiten Spannungsteilerwiderstand (R22) enthält, wobei die Offset-Spannungs-Zuführungsschaltung (312) konfiguriert ist, dem Komparator (300) auf der Grundlage einer ersten Referenzspannung VR1 eine Offset-Spannung zuzuführen.

11. Induktionsheizvorrichtung nach einem der vorhergehenden Ansprüche 1-10, wobei die Steuereinheit (2) konfiguriert ist, einen Durchschnittswert der von der Eingangsstrom-Erfassungsschaltung (31, 33) ausgegebenen Stromwerte als den Eingangsstromwert der Wechselrichterschaltung (212, 214) zu bestimmen.

12. Induktionsheizvorrichtung nach einem der vorhergehenden Ansprüche 1-11, wobei die Steuereinheit (2) konfiguriert ist, den von der Resonanzstrom-Erfassungsschaltung (32, 34) ausgegebenen Stromwert als den Resonanzstromwert der Arbeitsspule (132, 142) zu bestimmen.

13. Induktionsheizvorrichtung nach einem der vorhergehenden Ansprüche 2-12, wobei die Eingangsstrom-Erfassungsschaltung (31, 33) und die Resonanzstrom-Erfassungsschaltung (32, 34) konfiguriert sind, Stromsignale mit unterschiedlichen Frequenzen zu erfassen.

14. Induktionsheizvorrichtung nach einem der vorhergehenden Ansprüche, wobei die von der Eingangsstrom-Erfassungsschaltung (31, 33) und von der Resonanzerfassungsschaltung (32, 34) ausgegebenen Stromwerte positive Werte sind.

## Revendications

1. Dispositif de chauffage par induction (10) comportant :
une bobine de travail (132, 142) disposée dans une position correspondant à une zone de chauffage (12, 14) ;
un circuit inverseur (212, 214) comportant une pluralité d'éléments de commutation (SW1, SW2, SW3, SW4) et configuré pour fournir un courant à la bobine de travail (132, 142) ;
un circuit redresseur (202) configuré pour redresser la tension fournie à partir d'une source d'alimentation externe (20) ;
un circuit de lissage (203) configuré pour lisser la tension délivrée à la sortie du circuit redresseur (202) ;
un circuit d'excitation (22) configuré pour fournir un signal de commutation (S1, S2, S3, S4) à chacun des circuits de commutation (SW1, SW2, SW3, SW4) ;
une commande (2) configurée pour fournir un signal de commande au circuit d'excitation (22) pour délivrer en sortie le signal de commutation (S1, S2, S3, S4) par le circuit d'excitation (22) ;
une résistance shunt (RS1, RS2) connectée entre le circuit de lissage (203) et le circuit inverseur (212, 214),
**caractérisé par**
un circuit de détection de courant (31, 32, 33, 34) configuré pour détecter une valeur de courant d'entrée du circuit inverseur (212) sur la base d'un courant circulant à travers la résistance shunt (RS1, RS2) et pour détecter une valeur de courant de résonance de la bobine de travail (132, 142) sur la base du courant circulant à travers la résistance shunt (RS1, RS2), dans lequel le circuit de détection de courant (31, 32, 33, 34) comporte :
un circuit de détection de courant d'entrée (31, 33) configuré pour détecter une valeur de courant d'entrée du circuit inverseur (212) sur la base d'un courant circulant à travers la résistance shunt (RS1, RS2) ; et
un circuit de détection de courant de résonance (32, 34) configuré pour détecter une valeur de courant de résonance de la bobine de travail (132, 142) sur la base du courant circulant à travers la résistance shunt (RS1, RS2)

2. Dispositif de chauffage par induction selon la revendication 1, dans lequel le circuit de détection de courant d'entrée (31, 33) est connecté en parallèle à la résistance shunt (RS1, RS2) ; et/ou le circuit de détection de courant de résonance (32, 34) est connecté en parallèle à la résistance shunt (RS1, RS2).

3. Dispositif de chauffage par induction selon la revendication 1 ou 2, dans lequel le circuit de détection de courant d'entrée (31, 33) et le circuit de détection de courant de résonance (32, 34) ont les mêmes composants.

4. Dispositif de chauffage par induction selon l'une quelconque des revendications précédentes, dans lequel le circuit de détection de courant (31, 33) comporte :
un circuit d'alimentation en tension de décalage (312) ;
un comparateur (300) configuré pour délivrer en sortie une valeur numérique correspondant à l'amplitude du courant circulant à travers la résistance de shunt (RS1, RS2).

5. Dispositif de chauffage par induction selon l'une quelconque des revendications précédentes, dans lequel le circuit de détection de courant (31, 32, 33, 34) comporte un filtre de bruit (314).

6. Dispositif de chauffage par induction selon la revendication 5, dans lequel le circuit de filtre de bruit (314) inclut un condensateur (C11) et est configuré pour éliminer le bruit lorsque la première bobine de travail (132) et la seconde bobine de travail (142) sont excitées simultanément.

7. Dispositif de chauffage par induction selon l'une quelconque des revendications 2 à 6 précédentes, dans lequel le circuit de détection de courant d'entrée (31, 33) comporte un premier circuit de filtre passe-bas (316) configuré pour laisser passer un signal ayant une première fréquence prédéfinie ou une fréquence inférieure.

8. Dispositif de chauffage par induction selon l'une quelconque des revendications précédentes, dans lequel le circuit de détection de courant de résonance (32, 34) comporte un second circuit de filtre passe-bas (316) configuré pour laisser passer un signal ayant une seconde fréquence prédéfinie ou une fréquence inférieure.

9. Dispositif de chauffage par induction selon la revendication 7 ou 8, dans lequel le premier circuit de filtre passe-bas (316) et/ou le second circuit de filtre passe-bas (316) est un circuit de filtre RF comportant un élément résistif (R41) ayant une valeur de résistance prédéterminée et un élément capacitif (C21) ayant une valeur capacitive prédéterminée.

10. Dispositif de chauffage par induction selon l'une quelconque des revendications 4 à 9 précédentes, dans lequel le circuit d'alimentation en tension de décalage (312) inclut une première résistance de division de tension (R21) et une seconde résistance de division de tension (R22), dans lequel le circuit d'alimentation en tension de décalage (312) est configuré pour fournir une tension de décalage au comparateur (300) sur la base d'une première tension de référence (VR1).

11. Dispositif de chauffage par induction selon l'une quelconque des revendications 1 à 10 précédentes , dans lequel la commande (2) est configurée pour déterminer une valeur moyenne des valeurs de courant délivrées à la sortie du circuit de détection de courant d'entrée (31, 33) comme étant la valeur de courant d'entrée du circuit inverseur (212, 214).

12. Dispositif de chauffage par induction selon l'une quelconque des revendications 1 à 11 précédentes, dans lequel la commande (2) est configurée pour déterminer la valeur de courant délivrée à la sortie du circuit de détection de courant de résonance (32, 34) comme étant la valeur de courant de résonance de la bobine de travail (132, 142).

13. Dispositif de chauffage par induction selon l'une quelconque des revendications 2 à 12 précédentes, dans lequel le circuit de détection de courant d'entrée (31, 33) et le circuit de détection de courant de résonance (32, 34) sont configurés pour détecter des signaux de courant ayant des fréquences différentes.

14. Dispositif de chauffage par induction selon l'une quelconque des revendications précédentes, dans lequel les valeurs de courant délivrées à la sortie du circuit de détection de courant d'entrée (31, 33) et le circuit de détection de résonance (32, 34) sont des valeurs positives.
